Europäisches Patentamt

European Patent Office

Office européen des brevets

(11) Numéro de publication: **0 539 260 B1**

(12) **FASCICULE DE BREVET EUROPEEN**

(45) Date de publication du fascicule du brevet: **29.11.95**

(51) Int. Cl.6: **C23C 14/02**, C23C 14/20, G02F 1/1343, C08J 7/12

(21) Numéro de dépôt: **92402768.3**

(22) Date de dépôt: **09.10.92**

(54) **Procédé pour la métallisation de la surface de pièces en matériau plastique.**

(30) Priorité: **22.10.91 FR 9113010**

(43) Date de publication de la demande:
**28.04.93 Bulletin 93/17**

(45) Mention de la délivrance du brevet:
**29.11.95 Bulletin 95/48**

(84) Etats contractants désignés:
**DE GB IT**

(56) Documents cités:
**EP-A- 0 407 129**
**US-A- 4 444 848**

(73) Titulaire: **THOMSON-CSF**
**173, Boulevard Haussmann**
**F-75008 Paris (FR)**

(72) Inventeur: **Brule, Michel**
**Thomson-SCF,**
**SCPI,**
**Cedex 67**
**F-92045 Paris La Defence (FR)**
Inventeur: **Cosson, Michel**
**Thomson-SCF,**
**SCPI,**
**Cedex 67**
**F-92045 Paris La Defence (FR)**

(74) Mandataire: **Albert, Claude et al**
**THOMSON-CSF**
**SCPI**
**B.P. 329**
**50, rue J.P. Timbaud**
**F-92402 COURBEVOIE CEDEX (FR)**

Rank Xerox (UK) Business Services
(3.10/3.09/3.3.3)

EP 0 539 260 B1

## Description

La présente invention se rapporte à un procédé pour la métallisation de la surface de pièces en matériau plastique et aux pièces à usage électronique obtenues par ce procédé.

En électronique notamment, on cherche de plus en plus souvent à remplacer des pièces métalliques par des pièces en matériau plastiques plus légères, moins coûteuses et aussi résistantes. Ces pièces en matériau plastique doivent toutefois être métallisées pour présenter les performances électriques nécessaires.

On sait déjà métalliser certains matériaux plastiques courants ou même plus récents, comme le polyéthersulfone, utilisés dans une large gamme d'applications industrielles.

Dans le domaine des hyperfréquences en général et surtout dans le domaine des ondes millimétriques, il est nécessaire de trouver des matériaux plastiques permettant la fabrication de pièces de grande précision. C'est ainsi qu'ont été mis au point des matériaux plastiques nouveaux permettant la fabrication par injection de pièces avec des tolérances très faibles sur les dimensions grâce à un écoulement orienté en couches lamellaires. C'est le cas par exemple des polymères à cristaux liquides (à résine de base polyester) pouvant être renforcés par des charges minérales.

Cependant, l'inconvénient de ces matériaux est que l'on ne sait pas actuellement les métalliser convenablement de manière à obtenir les caractéristiques d'adhérence de dépôt et de conductivité et d'homogénéité de surface nécessaires pour les applications hyperfréquences envisagées, ainsi que la possibilité de report de composants par brasage tendre.

La demande de brevet EP-A- 0 407 129 décrit un procédé de métallisation d'un matériau plastique constitué d'un polymère à cristaux liquides à charge minérale. Ce procédé consiste à effectuer un décapage de la surface du matériau soit par un traitement sous vide soit par voie chimique, suivi par un dépôt métallique sous vide. Ceci permet d'obtenir des pièces en matériau plastique métallisé utilisables par exemple pour des circuits imprimés.

Un objet de la présente invention est donc un procédé de métallisation de matériau plastique remédiant à ces inconvénients.

Selon l'invention, il est prévu un procédé pour la métallisation de la surface de pièces en matériau plastique, constitué par des polymères à cristaux liquides avec charges minérales, tel que défini dans les revendications.

Dans un mode de réalisation particulier, ce procédé met à profit la grande cohésion du palladium avec l'argent et les grandes qualités d'adhérence du palladium lorsque la surface du matériau a été préparée et activée comme indiqué.

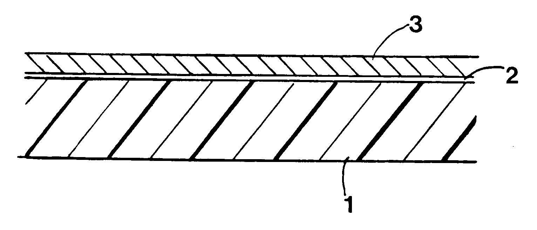

L'invention sera mieux comprise et d'autres caractéristiques et avantages apparaîtront à l'aide de la description ci-après et de la figure unique jointe montrant en coupe un exemple de pièce selon l'invention.

Comme on l'a déjà mentionné plus haut, le problème de la métallisation de matériaux plastiques résolu par l'invention est particulièrement difficile dans le cas des matériaux utilisant un polymère à cristaux liquides à charge minérale. Un exemple typique d'un tel matériau est le VECTRA (LCX-325 ou C 810 notamment), marque déposée, distribué par la Société Hoechst, ou encore le XYDAR, marque déposée.

On décrira le procédé selon l'invention dans le cadre de son application au VECTRA sans que cela soit en rien limitatif de l'invention.

Pour métalliser une pièce obtenue par injection de ce matériau plastique, le procédé selon l'invention prévoit de déposer d'abord sur la surface préparée et activée de la pièce une sous-couche mince d'un métal d'accrochage par pulvérisation cathodique puis de déposer une couche finale de métal très bon conducteur électrique par pulvérisation cathodique.

Plus particulièrement pour le VECTRA on utilise pour la sous-couche un métal de la mine de platine, et de préférence le palladium, et, pour la couche finale, de l'argent pur qui a une très bonne cohésion avec le palladium et qui donne les qualités électriques requises pour les applications électroniques même en ondes millimétriques, à savoir un état de surface aussi parfait que possible avec une très grande homogénéité et la conductivité voulue. De plus, le couple palladium-argent a les qualités galvaniques souhaitées pour offrir une très grande résistance aux environnements sévères (brouillards salins, ...).

Le palladium offre une très bonne adhérence au matériau plastique dans la mesure où la surface de celui-ci a été convenablement préparée.

Une mise en oeuvre préférée du procédé selon l'invention est décrite en détails ci-dessous en se référant également à la figure annexée.

Dans une première étape, la pièce en VECTRA (référence 1 sur la figure annexée) subit une préparation par voie chimique dans un bain d'hydroxyde alcalin, par exemple d'hydroxyde de potassium. Ce conditionnement permet l'élimination des pollutions de surface et crée un micro-satinage de la surface de la pièce. Les paramètres de cette première étape doivent être convenablement réglés pour éviter les craquelures ou fissures tout en assurant le micro-satinage.

On obtient ces résultats avec une concentration du bain comprise sensiblement entre 380 et 420 g/l à une température comprise sensiblement entre 75 et 85°C et une durée de l'ordre de 10mn ± 1 mn afin d'obtenir une rugosité suffisante mais inférieure à 2 $\mu$m.

La seconde étape est une opération d'étuvage permettant la déshydratation et le dégazage des pièces. Celle-ci s'effectue à une température de 125°C ± 5 pendant 2 h ± 30 mn.

La troisième étape est une étape d'activation par l'action mécanique d'un plasma d'argon. Cette opération est essentielle pour la qualité et l'adhérence des couches métalliques. Les paramètres sont optimisés afin de ne pas dégrader les pièces par échauffement.

L'opération s'effectue dans un bâti de dépôt sous vide, ce qui a l'avantage de parachever la déshydration et le dégazage de la pièce.

On choisit une pression partielle d'argon sensiblement égale à 2 Pa avec intensité de plasma de 0,4A ± 0,05A et la durée de l'opération est de 5 mn ± 30s.

Les ions d'argon du plasma ont un rôle d'activateur et de microbillage de la surface car ils viennent bombarder la pièce.

La quatrième étape du procédé consiste à déposer une sous-couche mince de palladium très pur (référence 2 sur la figure annexée). On prend par exemple une épaisseur de la sous-couche comprise sensiblement entre 2000 et 2500 Å. C'est ce dépôt microcristallin qui, avec les paramètres adéquats, permet d'assurer le lien d'adhérence entre le VECTRA et la couche d'argent.

Le dépôt s'effectue par pulvérisation cathodique magnétron sous une pression partielle d'argon de l'ordre de 0,4 Pa avec une intensité de pulvérisation de 4A ± 0,05A pendant une durée de 15mn ± 1 mn.

Enfin la cinquième étape du procédé consiste à déposer la couche finale d'argent pur (référence 3 sur la figure). Cette couche peut avoir une épaisseur sensiblement comprise entre 8 et 10 $\mu$m.

Le dépôt s'effectue par pulvérisation cathodique magnétron sous une pression partielle d'argon de l'ordre de 0,5 Pa avec une intensité de pulvérisation de 4A ± 0,05A pendant une durée de 60 mn ± 5 nm.

Ce dépôt d'argent présente une parfaite continuité, un état de surface exempt de défaut (rugosité inférieure à 2 $\mu$m), une très grande adhérence au matériau plastique et autorise les brasages tendres. De plus, ces caractéristiques se conservent parfaitement après vieillissement simulé par des variations rapides de température

$$(1000 \text{ cycles } (-55°C/+125°C) \text{ avec } 1 \text{ cycle } = \left\{ \begin{array}{l} 30 \text{ minutes} - 55°C \\ 30 \text{ minutes} + 125°C \end{array} \right).$$

Une caractéristique particulière des couches métalliques 2 et 3 est que, étant obtenues par pulvérisation cathodique, elles ont une constitution microcristallographique à structure colonnaire.

Bien entendu, les exemples de réalisation décrits ne sont nullement limitatifs de l'invention. On peut utiliser pour la sous-couche 2 d'autres métaux de la mine de platine. De même, il serait possible d'utiliser pour la couche finale 3 des métaux bons conducteurs électriques autres que l'argent,tels que l'or, le cuivre, etc ...

**Revendications**

1. Procédé pour la métallisation de la surface de pièces en matériau plastique constitué par des polymères à cristaux liquides avec charges minérales, comprenant une étape de préparation de surface et une étape de dépôt d'une couche métallique par pulvérisation cathodique, ladite étape de préparation de surface comprenant les étapes successives de :
   - préparer par voie chimique la surface desdites pièces en matériau plastique pour obtenir un micro-satinage en conditionnant lesdites pièces dans un bain d'hydroxyde alcalin ;
   - étuver pour déshydrater et dégazer lesdites pièces ;
   - activer ladite surface micro-satinée par l'action d'un plasma ; et l'étape de dépôt d'une couche métallique comprenant les étapes successives de :
   - déposer une sous-couche mince d'un métal d'accrochage par pulvérisation cathodique ;
   - déposer une couche finale de métal très bon conducteur électrique par pulvérisation cathodique.

**2.** Procédé selon la revendication 1, caractérisé en ce que ledit hydroxyde alcalin étant de l'hydroxyde de potassium, lesdites pièces sont plongées dans le bain ayant une concentration comprise sensiblement entre 380 et 420 g/l et une température comprise sensiblement entre 75 et 85°C pendant une durée comprise sensiblement entre 9 et 11 mn.

**3.** Procédé selon la revendication 2, caractérisé en ce que ledit étuvage est effectué à une température de l'ordre de 125°C pendant une durée sensiblement égale à 2 h ± 30 mn.

**4.** Procédé selon l'une quelconque des revendications 2 ou 3, caractérisé en ce que ladite étape d'activation comprend l'activation par un plasma d'argon.

**5.** Procédé selon la revendication 4, caractérisé en ce que ladite étape d'activation s'effectue dans un bâti de dépôt sous vide sous une pression partielle d'argon sensiblement égale à 2 Pa avec une intensité du plasma de l'ordre de 0,4A pendant une durée de l'ordre de 5 mn.

**6.** Procédé selon l'une quelconque des revendications 1 à 5, caractérisé en ce que ledit métal d'accrochage est du palladium.

**7.** Procédé selon la revendication 6, caractérisé en ce que ladite étape de dépôt d'une sous-couche de palladium consiste à déposer par pulvérisation cathodique magnétron une couche de palladium dont l'épaisseur est sensiblement comprise entre 0,2 et 0,25 $\mu$m (2000 et 2500 $\mathring{A}$)

**8.** Procédé selon la revendication 7, caractérisé en ce que ladite étape de dépôt d'une sous-couche de palladium s'effectue sous une pression partielle d'argon sensiblement égale à 0,4 Pa avec une intensité de pulvérisation de l'ordre de 4A pendant une durée de l'ordre de 15 mn.

**9.** Procédé selon l'une quelconque des revendications 1 à 8, caractérisé en ce que ledit métal très bon conducteur électrique de ladite couche finale est de l'argent.

**10.** Procédé selon la revendication 9, caractérisé en ce que ladite étape de dépôt d'une couche finale d'argent consiste à déposer par pulvérisation cathodique magnétron une couche d'argent dont l'épaisseur est sensiblement comprise entre 8 et 10 $\mu$m.

**11.** Procédé selon l'une des revendications 9 ou 10, caractérisé en ce que ladite étape de dépôt d'une couche finale d'argent consiste à déposer une couche d'argent par pulvérisation cathodique magnétron sous une pression partielle d'argon sensiblement égale à 0,5 Pa avec une intensité de pulvérisation de l'ordre de 4A pendant une durée de l'ordre de 60 mn.

**Claims**

**1.** Process for the metallization of the surface of articles made of plastic consisting of liquid-crystal polymers with inorganic fillers, including a step of surface preparation and a step of deposition of a metal layer by cathode sputtering, the said step of surface preparation including the successive steps of:

- preparing, by a chemical route, the surface of the said articles made of plastic, to obtain a microsatin finish by conditioning the said articles in a bath of alkali metal hydroxide;
- treating in an oven to dehydrate and degas the said articles;
- activating the said microsatin-finished surface by the action of a plasma; and
- the step of deposition of a metal layer including the successive steps of:
- depositing a thin underlayer of a bonding metal by cathode sputtering;
- depositing a final layer of metal that is a very good electrical conductor by cathode sputtering.

**2.** Process according to Claim 1, characterized in that, the said alkali metal hydroxide being potassium hydroxide, the said articles are immersed in a bath which has a concentration of substantially between 380 and 420 g/l and a temperature of substantially between 75 and 85°C for a period of substantially between 9 and 11 min.

3. Process according to Claim 2, characterized in that the said oven treatment is performed at a temperature of the order of 125° for a period substantially equal to 2 h ± 30 min.

4. Process according to either of Claims 2 and 3, characterized in that the said activation step includes the activation with an argon plasma.

5. Process according to Claim 4, characterized in that the said activation step is performed in a vacuum deposition system at a partial pressure of argon substantially equal to 2 Pa with a plasma intensity of the order of 0.4 A for a period of the order of 5 min.

6. Process according to any one of Claims 1 to 5, characterized in that the said bonding metal is palladium.

7. Process according to Claim 6, characterized in that the said step of deposition of an underlayer of palladium consists in depositing by magnetron cathode sputtering a layer palladium whose thickness is substantially between 0.2 and 0.25 $\mu$m (2000 and 2500 Å).

8. Process according to Claim 7, characterized in that the said step of deposition of an underlayer of palladium is performed at a partial pressure of argon substantially equal to 0.4 Pa with a sputtering intensity of the order of 4 A for a period of the order of 15 min.

9. Process according to any one of Claims 1 to 8, characterized in that the said metal that is a very good electrical conductor of the said final layer is silver.

10. Process according to Claim 9, characterized in that the said step of deposition of a final layer of silver consists in depositing by magnetron cathode sputtering a layer of silver whose thickness is substantially between 8 and 10 $\mu$m.

11. Process according to either of Claims 9 and 10, characterized in that the said step of deposition of a final layer of silver consists in depositing a layer of silver by magnetron cathode sputtering at a partial pressure of argon substantially equal to 0.5 Pa with a sputtering intensity of the order of 4 A for a period of the order of 60 min.

**Patentansprüche**

1. Verfahren zur Metallisierung der Oberfläche von Kunststoffteilen, die aus Flüssigkristallpolymeren mit mineralischen Füllstoffen bestehen, das einen Schritt der Oberflächenvorbereitung und einen Schritt des Aufbringens einer Metallschicht durch Kathoden-Sputtern aufweist, wobei der Schritt der Oberflächenvorbereitung die aufeinanderfolgenden Schritte aufweist:
   - Vorbereiten der Oberfläche der Kunststoffteile auf chemischem Wege, um eine Mikrosatinierung zu erhalten, indem die Teile in einem alkalischen Hydroxidbad behandelt werden;
   - Trocknen, um die Teile zu entwässern und zu entgasen;
   - Aktivieren der mikrosatinierten Oberfläche durch Einwirkung eines Plasmas; und wobei der Schritt des Aufbringens einer Metallschicht die aufeinanderfolgenden Schritte aufweist:
   - Aufbringen einer Subdünnschicht eines Haftmetalls durch Kathoden-Sputtern;
   - Aufbringen einer elektrisch sehr gut leitenden Metallendschicht durch Kathoden-Sputtern.

2. Verfahren nach Anspruch 1, dadurch gekennzeichnet, daß die Teile in das Bad mit einer Konzentration von im wesentlichen zwischen 380 und 420 g/l und einer Temperatur von im wesentlichen zwischen 75 und 85°C über eine Zeitdauer von im wesentlichen zwischen 9 und 11 min eingetaucht werden, da das alkalische Hydroxid Kaliumhydroxid ist.

3. Verfahren nach Anspruch 2, dadurch gekennzeichnet, daß das Trocknen bei einer Temperatur in der Größenordnung von 125°C über eine Zeitdauer von im wesentlichen gleich 2h ± 30 min durchgeführt wird.

4. Verfahren nach einem der Ansprüche 2 oder 3, dadurch gekennzeichnet, daß der Aktivierungsschritt die Aktivierung durch ein Argonplasma umfaßt.

5. Verfahren nach Anspruch 4, dadurch gekennzeichnet, daß der Aktivierungsschritt in einem Vakuumabscheidungsgehäuse unter einem Argonpartialdruck von im wesentlichen gleich 2 Pa mit einer Plasmastärke in der Größenordnung von 0,4 A über eine Zeitdauer in der Größenordnung von 5 min durchgeführt wird.

6. Verfahren nach einem der Ansprüche 1 bis 5, dadurch gekennzeichnet, daß das Haftmetall Palladium ist.

7. Verfahren nach Anspruch 6, dadurch gekennzeichnet, daß der Schritt des Aufbringens einer Palladiumsubschicht darin besteht, durch Magnetron-Kathodensputtern eine Palladiumschicht aufzubringen, die im wesentlichen zwischen 0,2 und 0,25.m (2000 und 2500 ) dick ist.

8. Verfahren nach Anspruch 7, dadurch gekennzeichnet, daß der Schritt des Aufbringens einer Palladiumsubschicht unter einem Argonpartialdruck von im wesentlichen gleich 0,4 Pa mit einer Sputter-Stärke in der Größenordnung von 4 A über einen Zeitraum in der Größenordnung von 15 min durchgeführt wird.

9. Verfahren nach einem der Ansprüche 1 bis 8, dadurch gekennzeichnet, daß das elektrisch sehr gut leitende Metall der Endschicht Silber ist.

10. Verfahren nach Anspruch 9, dadurch gekennzeichnet, daß der Schritt des Aufbringens einer Endschicht aus Silber darin besteht, durch Magnetron-Kathodensputtern eine Silberschicht aufzubringen, deren Dicke im wesentlichen zwischen 8 und 10 .m liegt.

11. Verfahren nach einem der Ansprüche 9 oder 10, dadurch gekennzeichnet, daß der Schritt des Aufbringens einer Endschicht aus Silber darin besteht, eine Silberschicht durch Magnetron-Kathodensputtern unter einem Argonpartialdruck von im wesentlichen gleich 0,5 Pa mit einer Sputter-Stärke in der Größenordnung von 4 A über einen Zeitraum in der Größenordnung von 60 min aufzubringen.